# EUROPEAN PATENT APPLICATION

(11) **EP 1 394 869 A2**
(43) Date of publication of application: **03.03.2004**
(21) Application number: 03018759.5
(22) Date of filing: 27.08.2003
(51) Int. Cl.: H01L 51/20

(54) **Method of forming protection film for covering electronic component and electronic device having protection film**

(30) Priority: 30.08.2002 JP 2002254613
(71) Applicant: Tohoku Pioneer Corp., Tendo-shi, Yamagata 994-8585 (JP)
(72) Inventor: Ohata, Hiroshi, Tsurugashima-shi Saitama, 350-2201 (JP); Ogushi, Kunizo, Yonezawa-shi Yamagata, 992-1128 (JP); Kimura, Masami, Yonezawa-shi Yamagata, 992-1128 (JP)
(74) Representative: HOFFMANN - EITLE

(57) **Abstract**

A method for forming a protection film capable of effectively sealing an organic EL device mounted on a surface of a substrate is provided, for example.

Crucibles 15a to 15c as vapor sources are disposed facing the organic EL device 2 mounted on the surface of the transparent substrate 1. There is also provided a mask 11 having an opening 11a facing the organic EL device 2 and the mask 11 is disposed between the substrate 1 and a crucible 15. Distances of the mask 11 from the substrate are progressively increased and materials evaporated from the crucibles 15a to 15c are selected, to thereby form a first layer of protection film 21 for covering the EL device 2, a second layer of protection film 22 for covering beyond the first layer of protection film, and further third or more layers of protection films similarly.

## Description

### BACKGROUND OF THE INVENTION

### 1. Field of the Invention

The present invention relates to a method of forming a protection film for covering an electronic component mounted on a surface of a substrate and an electronic device having the protection film, in particular to a method of forming such a protection film for protecting an organic electroluminescence (EL) device mounted on a surface of a transparent substrate so as to maintain a luminescence characteristic of the device in a good state, for example.

### 2. Description of Related Art

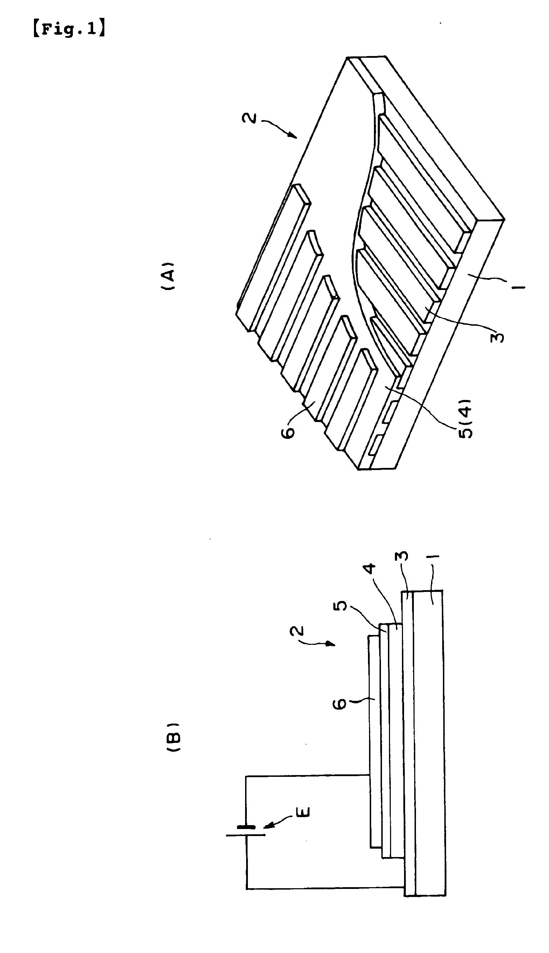

As shown in FIGS. 1(A) and 1(B), an organic EL device is configured as layers on a surface of a transparent substrate 1.

FIG. 1(A) illustrates the organic EL device partially cut away in a perspective view, and FIG. 1(B) illustrates a state of layers in a cross-sectional view. In other words, the organic EL device 2 as the layers is such that a first electrode 3 is formed in stripes on the transparent substrate 1 by means of a sputtering process, for example, and a positive hole transport layer 4 is formed thereon by means of a vapor deposition process, for example. Further, a luminescence material layer 5 of an organic compound is similarly formed on the positive hole transport layer 4 by means of a vapor deposition process. Still further, a plurality of second electrodes 6 are formed on the luminescence material layer 5 of an organic compound in the direction perpendicular to the direction of the first electrode. FIG. 1(A) shows one layer of the luminescence material layer 5 and one layer of the positive hole transport layer 4 by way of example.

As shown in FIG. 1(B), when a positive electrode and a negative electrode of a direct current power supply E are selectively connected to the first electrode 3 and the second electrode 6 respectively, a positive hole from the first electrode 3 and an electron from the second electrode 6 recombine at a pixel position where the first electrode 3 and the second electrode 6 intersect so as to emit light. The light due to the light-emission or luminescence is taken out via the transparent substrate 1.

The substrate 1 as mentioned above may be of transparent glass, quartz, sapphire, or organic film. The positive electrode 3 as the first electrode may be of indium tin oxide (ITO). An aluminum alloy, for example, may be used for the negative electrode 6 as the second electrode. The thus constructed organic EL device 2 has a problem in that the layers are exposed to atmosphere in particular the negative electrode 6 tends to be oxidized by moisture included in the atmosphere so as to degrade the luminescence characteristic. To avoid such a problem, Japanese Patent Application Laid-open (kokai) H09-148066 discloses an organic EL device formed of layers sealed by an airtight container and a transparent substrate in which a drying desiccant is included.

According to the above described constitution, a box-shaped stainless steel container in which one surface is open is used as the airtight container so as to be adhered to the transparent substrate by means of an adhesive, to thereby seal the organic EL device formed of the laminate. However, according to the above-described constitution, the above-mentioned container considerably increases the thickness of a luminescence display panel.

Although the above described organic EL device employs the organic film, for example, as the transparent substrate so as to provide a characteristic of a flexible luminescence display panel, such a characteristic may not be utilized when using such a metal container as mentioned above as a sealing member. On the other hand, Japanese Patent Application Laid-open (kokai) 2000-223264 discloses a method of sealing an organic EL device not by means of the airtight container but by means of a laminated protection film having an inorganic film and an organic film, which facilitates to manufacture a flexible luminescence panel by means of sealing using the protection films. However, a problem arises in that in the case of a plurality of protection films a mask corresponding in size to each of the protection film must be employed. Further the plurality of protection films cause to increase in the frequency of replacing the masks, need a chamber (film forming chamber) corresponding to each mask and more spaces for storing the masks, and increase the number of manufacturing processes, for example.

Based on the technical view as described above the present invention has been made and aims to provide a method of forming a protection film capable of effectively sealing an electronic component mounted on a surface of a substrate represented by the organic EL display panel as described above, for example, and further to provide a new structure of an electronic device represented by the organic EL display panel having the above-mentioned protection film for sealing.

### SUMMARY OF THE INVENTION

As will be defined in claim 1, a method of forming a protection film for covering an electronic component according to the present invention in order to achieve the aim set forth above is a method of forming at least two layers of protection films for covering an electronic component mounted on a surface of a substrate, the method comprising: a film forming step where a mask having an opening corresponding to the electronic component mounted on the surface of the substrate is disposed apart from the substrate by a predetermined first distance, and a film forming material is deposited through the opening of the mask onto the substrate and the electronic component as a first layer of protection film; and a film forming step where the mask is disposed apart from the substrate by a second distance longer than the first distance, and a film forming material is deposited through the opening of the mask onto the substrate and the electronic component as a second layer of protection film, wherein the steps are performed in turn, thereby at least forming the first layer of protection film for covering the electronic component and the second layer of protection film for covering beyond the first layer of protection film.

As will be defined in claim 2, a method of forming a protection film for covering an electronic device according to the present invention is a method of forming at least two layers of protection films for covering an electronic component mounted on a surface of a substrate, the method comprising: a film forming step where a mask having an opening corresponding to the electronic component mounted on the surface of the substrate is disposed between the substrate and a vapor source and a film forming material from the vapor source is deposited, through the opening of the mask apart from the substrate by a predetermined first distance, onto the substrate and the electronic component as a first layer of protection film; and a film forming step where the mask is disposed apart from the substrate by a second distance longer than the first distance, and a film forming material is deposited through the opening of the mask onto the substrate and the electronic component as a second layer of protection film, wherein the steps are performed in turn maintaining a distance between the substrate and the vapor source constant, thereby at least forming the first layer of protection film for covering the electronic component and the second layer of protection film for covering beyond the first layer of protection film.

As will be defined in claim 4, a method of forming a protection film for covering an electronic device according to the present invention is a method of forming at least two layers of protection films for covering an electronic component mounted on a surface of a substrate, the method comprising: a film forming step where a mask having an opening corresponding to the electronic component mounted on the surface of the substrate is disposed between the substrate and a vapor source, and a film forming material from the vapor source disposed apart from the substrate by a predetermined first distance is deposited through the opening of the mask onto the substrate and the electronic component as a first layer of protection film; and a film forming step where the vapor source is disposed apart from the substrate by a second distance shorter than the first distance, and a film forming material from the vapor source is deposited through the opening of the mask onto the substrate and the electronic component as a second layer of protection film, wherein the steps are performed in turn maintaining a distance between the substrate and the mask constant, thereby at least forming the first layer of protection film for covering the electronic component and the second layer of protection film for covering beyond the first layer of protection film.

On the other hand, as will be defined in claim 7, an electronic device having a protection film according to the present invention in order to achieve the aim set forth above is an electronic device having at least two layers of protection films so as to cover an electronic component mounted on a surface of a substrate, at least comprising: a first layer of protection film obtained by disposing a mask having an opening corresponding to the electronic component mounted on the surface of the substrate apart from the substrate by a predetermined first distance, and depositing a film forming material, through the opening of the mask, onto the substrate and the electronic component; and a second layer of protection film obtained by disposing the mask apart from the substrate by a second distance longer than the first distance, and depositing a film forming material, through the opening of the mask, onto the substrate and the electronic component, wherein the second layer of protection film is formed on the first layer of protection film so as to cover beyond the first layer of protection film.

As will be defined in claim 8, an electronic device having a protection film according to the present invention is an electronic device having at least two layers of protection films so as to cover an electronic component mounted on a surface of a substrate, at least comprising: a first layer of protection film obtained by disposing a mask having an opening corresponding to the electronic component mounted on the surface of the substrate between the substrate and a vapor source and depositing a film forming material from the vapor source, through the opening of the mask apart from the substrate by a predetermined first distance, onto the substrate and the electronic component; and a second layer of protection film obtained by disposing the mask apart from the substrate by a second distance longer than the first distance, and depositing a film forming material from the vapor source, through the opening of the mask, onto the substrate and the electronic component, wherein the second layer of protection film is formed on the first layer of protection film so as to cover beyond the first layer of protection film.

As will be defined in claim 9, an electronic device having a protection film according to the present invention is an electronic device having at least two layers of protection films so as to cover an electronic component mounted on a surface of a substrate, at least comprising: a first layer of protection film obtained by disposing a mask having an opening corresponding to the electronic component mounted on the surface of the substrate between the substrate and a vapor source and depositing a film forming material from the vapor source, through the opening of the mask apart from the substrate by a predetermined first distance, onto the substrate and the electronic component; and a second layer of protection film obtained by disposing the vapor source apart from the substrate by a second distance shorter than the first distance, and depositing a film forming material from the vapor source, through the opening of the mask, onto the substrate and the electronic component, wherein the second layer of protection film is formed on the first layer of protection film so as to cover beyond the first layer of protection film.

### BRIEF DESCRIPTION OF THE DRAWINGS

FIGS. 1(A) and 1(B) are schematic representations showing a lamination state of an organic EL device.
FIG. 2 is a schematic representation showing a film forming state of a first layer of protection film according to a first preferred embodiment of a film forming method according to the present invention.
FIG. 3 is a schematic representation showing a film forming state of a second layer of protection film according to the first preferred embodiment.
FIG. 4 is a schematic representation showing a film forming state of a third layer of protection film according to the first preferred embodiment.
FIG. 5 is a cross-sectional view showing an example of protection films formed by means of the film forming processes as shown in FIG. 2 to FIG. 4.
FIG. 6 is a schematic representation showing a film forming state of a first layer of protection film according to a second preferred embodiment of a film forming method according to the present invention.
FIG. 7 is a schematic representation showing a film forming state of a second layer of protection film according to the second preferred embodiment.
FIG. 8 is a schematic representation showing a film forming state of a third layer of protection film according to the second preferred embodiment.
FIG. 9 is a schematic representation showing a film forming state of a first layer of protection film according to a third preferred embodiment of a film forming method according to the present invention.
FIG. 10 is a schematic representation showing a film forming state of a second layer of protection film according to the third preferred embodiment.
FIG. 11 is a schematic representation showing a film forming state of a third layer of protection film according to the third preferred embodiment.
FIG. 12 is a schematic representation of a first example of a physical vapor-phase film forming process applicable to the film forming process according to the present invention.
FIG. 13 is a schematic representation of a second example of the physical vapor-phase film forming process.
FIG. 14 is a schematic representation of a third example of the physical vapor-phase film forming process.
FIG. 15 is a schematic representation of a fourth example of the physical vapor-phase film forming process.
FIGS. 16(A) to 16(D) are plan views for explaining constitutions of crucibles for accommodating film forming materials available for a film forming method according to the present invention and for explaining arrangements of the crucibles.

### DESCRIPTION OF THE PREFERRED EMBODIMENTS OF THE INVENTION

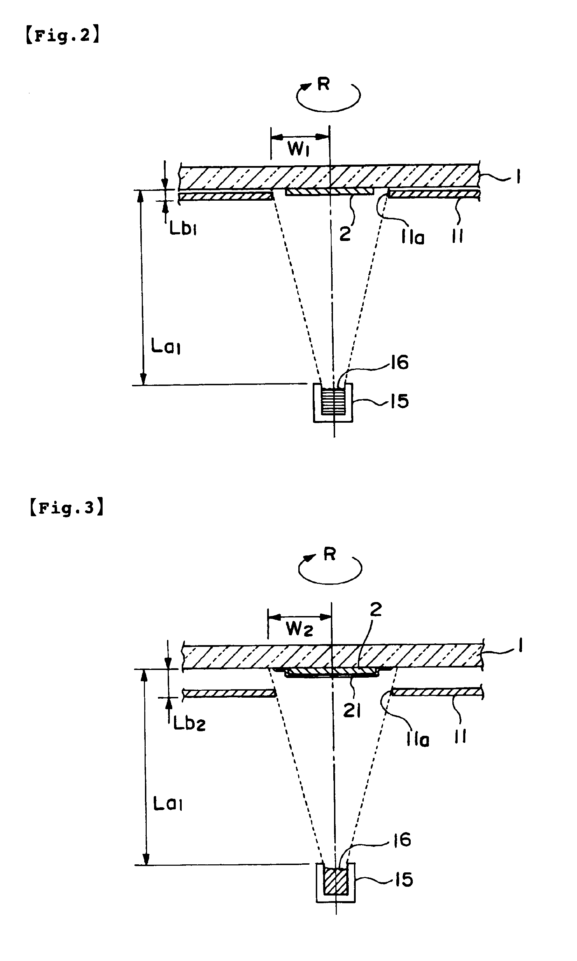

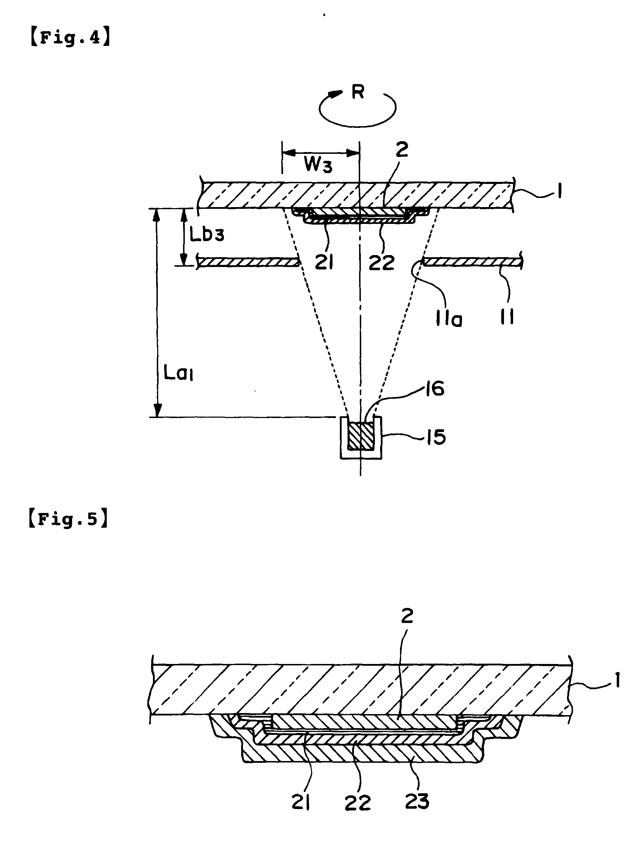

Hereafter, with reference to the drawings a method of forming a protection film for covering an electronic component according to the present invention will be described. FIG. 2 to FIG. 4 show a first preferred embodiment of the method along a film forming process with reference to the schematic representations. FIG. 5 shows, by way of a cross-sectional view, an example of protection films formed by means of the film forming processes as shown in FIG. 2 to FIG. 4. Reference numeral 1 in FIG. 2 to FIG. 4 denotes the transparent substrate as described above with reference to FIG. 1, reference numeral 2 indicates organic EL device(s) as electronic component(s) laminated to a surface of the transparent substrate, for example. In other words, as will be described, in order to protect the organic EL devices formed on the surface of the transparent substrate, a method of forming a plurality layers of protection films, however, the electronic component is not limited to the organic EL device, and the present invention may be similarly used for forming protection films for covering electronic components of other structures such as an inorganic EL device.

Firstly, as shown in FIG. 2 to FIG. 4, in a protection film forming apparatus according to the first preferred embodiment there is provided a mask 11 having an opening corresponding to the EL device 2 mounted on the surface of the substrate 1. In particular, at the above-mentioned-mask 11, there is formed an opening 11a having an area to cover substantially the entire surface of the EL device 2 formed on the substrate 1. In the preferred embodiment, a crucible 15 as a vapor source having an evaporation material 16 as a film forming material is disposed apart from the substrate 1 by a predetermined distance La1.

FIG. 2 shows a film forming process in which the mask 11 is disposed apart from the substrate 1 by a predetermined first distance Lb1 and the film forming material evaporated from the crucible 15 is deposited as the first layer of protection film, through the opening 11a formed at the mask 11, onto the substrate 1 and the EL device 2. In this case, the substrate 1 is rotated in the direction of the substrate surface as indicated by "R" in the figures such that a substantially central portion of the EL device 2 formed at the substrate 1 is a rotation axis, whereby the film forming material evaporated from the crucible 15 is deposited, through the opening 11a of the above-mentioned mask 11, onto the above-mentioned EL device 2 and its periphery on the substrate 1 as the first layer of protection film 21. In this case, the first layer of protection film 21 is deposited in an area within W1 from the rotation axis corresponding to the opening 11a formed at the mask 11.

FIG. 3 shows a film forming process in which a second layer of protection film is further deposited onto the substrate 1 and the EL device 2 having the deposited first layer of protection film 21 thereonto. In the process as shown in FIG. 3, while a position (distance La1), from the substrate 1, of the crucible 15 as the vapor source is not changed, the above-mentioned mask 11 facing the substrate 1 is moved to a position apart from the substrate 1 by a second distance Lb2 which is longer than the above-mentioned first distance Lb1. Through the opening 11a of the mask 11, the film forming material is deposited onto the above-mentioned substrate 1 and the EL device 2 as the second layer of protection film 22. In this case, the material 16 accommodated in the above-mentioned crucible 15 may be changed as appropriate.

Similarly, the substrate 1 is rotated in the direction of the substrate surface as indicated by "R" in FIG. 3 such that the substantially central portion of the EL device 2 formed at the substrate 1 is the rotation axis, whereby the film forming material evaporated from the crucible 15 is deposited, through the opening 11a of the above-mentioned mask 11, onto the above-mentioned EL device 2 and its periphery on the substrate 1 as the second layer of protection film 22. In this case, as shown in FIG. 3 the second layer of protection film 22 is deposited in an area within W2 from the rotation axis. At this point the distance La1 of the crucible 15 from the substrate 1 remains the same as described above and the distances of the mask 11 from the substrate 1 is represented by an expression Lb1 < Lb2, so that the film forming areas from the rotation axis are represented by an expression W1 < W2. Therefore, the second layer of protection film 22 is formed on the first layer of protection film 21 so as to cover beyond it.

FIG. 4 shows a film forming process of further depositing a third layer of protection film onto the substrate 1 and the EL device 2 where the second layer of protection film 22 has been deposited. In the process as shown in FIG. 4, without changing the position (the distance La1) relative to the substrate 1 of the crucible 15 as the vapor source, the above-mentioned mask 11 facing the substrate 1 is moved to a position apart from the substrate 1 by a third distance Lb3 which is longer than the above-mentioned second distance Lb2. Through the opening 11a of the mask 11, the film forming material is deposited onto the above-mentioned substrate 1 and the EL device 2 as the third layer of protection film 23. In this case, the evaporation material 16 accommodated in the above-mentioned crucible 15 may be changed as appropriate.

Similarly, the substrate 1 is rotated in the direction of the substrate surface as indicated by "R" in FIG. 4 such that the substantially central portion of the EL device 2 formed at the substrate 1 is the rotation axis, whereby the film forming material evaporated from the crucible 15 is deposited, through the opening 11a of the above-mentioned mask 11, onto the above-mentioned EL device 2 and its periphery on the substrate 1 as the third layer of protection film 23. In this case, as shown in FIG. 4 the third layer of protection film 23 is deposited in an area within W3 from the rotation axis. In other words, the distance La1 of the crucible 15 from the substrate 1 remains the same and the distances of the mask 11 from the substrate 1 is represented by an expression Lb2 < Lb3, so that the film forming areas from the rotation axis are represented by an expression W2 < W3. Therefore, the third layer of protection film 23 is formed on the second layer of protection film 22 so as to cover beyond it.

The above description is set forth until the third layer of protection film 23 is formed, however, fourth or more layers of protection films may be similarly formed as appropriate. As such FIG. 5 illustrates a state where the first to the third layers of protection films 21 to 23 are formed through the above-mentioned film forming processes. According to the structure of the protection films formed by means of the above-mentioned film forming processes, as shown in FIG. 5, the first layer of protection film 21 is formed so as to cover the EL device 2 and its periphery on the substrate 1, and the second layer of protection film 22 is formed so as to cover beyond the first layer of protection film 21. Similarly, the third layer of protection film 23 is formed so as to cover beyond the second layer of protection film 22 as well.

Therefore, according to the above-described preferred embodiment, it is possible to form a plurality of layers of protection films by using a sheet of mask, for example. Further, when a structure in which the EL device is coated with protection films is employed, each material used for each of the protection films may be suitably selected in order to effectively avoid a problem that the moisture included in atmosphere may affect a device such as the EL device so as to reduce its lifetime.

In addition, according to the structure of the above-mentioned protection films, compared with a conventional structure in which a metal seal container is used, the total thickness of the whole panel may be reduced. Further, using an organic film for the above-mentioned substrate, when employing a flexible material as a material of each protection film to coat the EL device, a flexible luminescence display panel having controlled the moisture may be obtained.

It should be understood that in the film forming process for the protection films as shown in FIG. 2 to FIG. 4, a so-called physical vapor-phase film forming process using the crucible 15 as the vapor source, however a chemical vapor-phase film forming process in which a film forming gas flows in the chamber may be used. In this case, through the opening 11a of the mask 11, a so-called going-around or wraparound of gas takes place on the substrate 1 side, in particular so-called "smearing" or "blur" also may take place. However, the thus obtained protection films have practically sufficient moisture resistance.

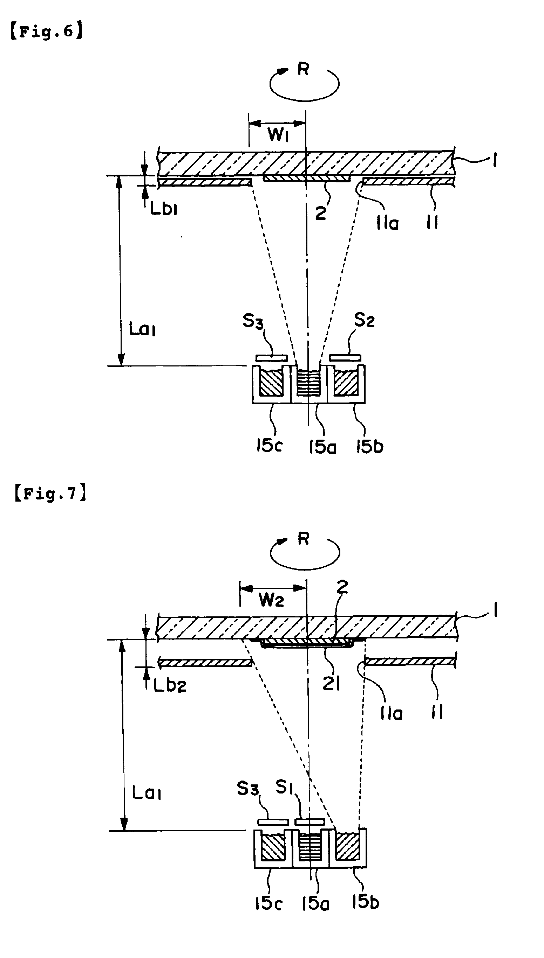

Next, FIG. 6 to FIG. 8 describe a second preferred embodiment of the film forming method according to the present invention. Note that in FIG. 6 to FIG. 8 the same reference numerals are used to indicate corresponding elements which have been already explained. Accordingly the detailed description of these elements will not be repeated herein. In a protection film forming apparatus as shown in FIG. 6 to FIG. 8, there are provided a plurality of crucibles 15a to 15c individually include film forming materials and are disposed in the same chamber. The crucibles 15a to 15c are respectively provided with shutters S1 to S3 as shown in FIG. 6 to FIG. 8.

In each of the processes as shown in FIG. 6 to FIG. 8, the same film forming operation as each of the processes as already described with reference to FIG. 2 to FIG. 4 is carried out. For this case, in the process of forming the first layer of protection film 21 as shown in FIG. 6, the shutter S1 provided for the first crucible 15a out of the shutters S1 to S3 respectively provided for the crucibles 15a to 15c is controlled to open. In other words, FIG. 6 indicates a state where the shutter S1 is not shown so that the film forming material may be evaporated from the first crucible 15a towards the substrate 1.

At this point, the shutters S2 and S3 respectively provided for the second and the third crucibles 15b and 15c close the crucible 15b and 15c, so that only the film forming material evaporated from the first crucible 15a is deposited onto the above-mentioned substrate 1 and the EL device 2 through the opening 11a formed at the mask 11 so as to be the first layer of protection film 21.

Subsequently, in the case of forming the second layer of protection film 22, the shutter S2 provided for the second crucible 15b is controlled to open as shown in FIG. 7. In other words, FIG. 7 indicates a state where the shutter S2 is not shown so that the film forming material may be evaporated from the second crucible 15b towards the substrate 1. At this point, the shutters S1 and S3 respectively provided for the first and the third crucibles 15a and 15c close the crucibles 15a and 15c, so that only the film forming material evaporated from the second crucible 15b is deposited onto the above-mentioned substrate 1 and the EL device 2 through the opening 11a formed at the mask 11 so as to be the second layer of protection film 22.

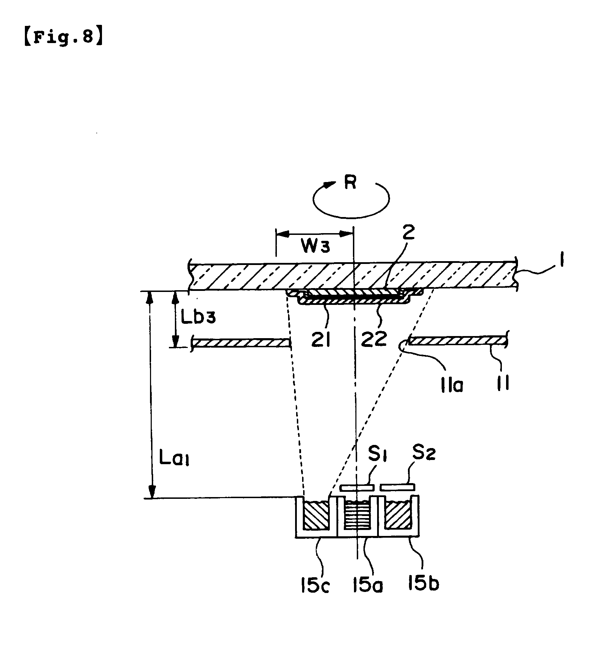

Further, in the case of forming the third layer of protection film 23, the shutter S3 provided for the third crucible 15c is controlled to open as shown in FIG. 8. In other words, FIG. 8 indicates a state where the shutter S3 is not shown so that the film forming material may be evaporated from the third crucible 15c towards the substrate 1. At this point, the shutters S1 and S2 respectively provided for the first and the second crucibles 15a and 15b close the crucibles 15a and 15b, so that only the film forming material evaporated from the third crucible 15c is deposited onto the above-mentioned substrate 1 and the EL device 2 through the opening 11a formed at the mask 11 so as to be the third layer of protection film 23.

As described above, when employing the film forming processes as shown in FIG. 6 to FIG. 8, operations and effects may be obtained similar to the film forming processes as shown in FIG. 2 to FIG. 4. The thus obtained structure of the protection films is similar to that shown in FIG. 5. In addition, in the film forming processes as shown in FIG. 6 to FIG. 8, each crucible with a shutter for individually accommodating a material for generating a film forming material therein is provided, so that while using the same mask a series of film forming processes may be carried out in the same chamber, to thereby improve its efficiency considerably.

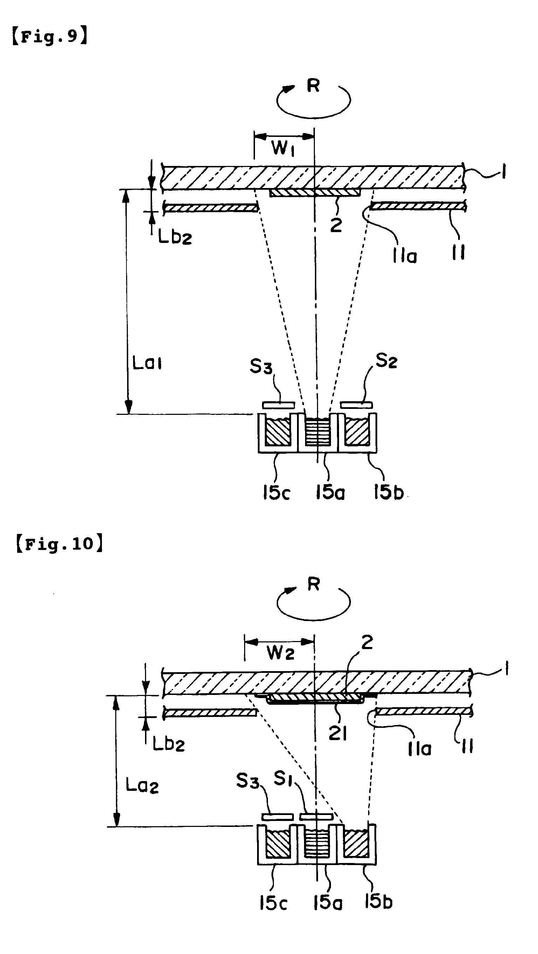

Next, FIG. 9 to FIG. 11 describe a third preferred embodiment of a method of forming such protection films according to the present invention. Note that in FIG. 9 to FIG. 11 the same reference numerals are used to indicate corresponding elements which have been already explained. Accordingly the detail description of these elements will not be repeated herein. In a protection film forming apparatus as shown in FIG. 9 to FIG. 11, there is also provided the mask 11 having the opening corresponding to the EL device 2 mounted on the surface of the substrate 1. Further there are provided the plurality of crucibles 15a to 15c individually include the material for generating the film forming material and are disposed in the same chamber. The crucibles 15a to 15c are respectively provided with shutters S1 to S3 as shown in FIG. 9 to FIG. 11.

In the preferred embodiment as shown in FIG. 9 to FIG. 11, while maintaining the distance between the substrate and the mask constant, the positions of the crucibles as the vapor sources for the substrate are rendered closer progressively so as to form the films. In other words, FIG. 9 shows a process in which the mask 11 is disposed apart from the substrate 1 having mounted the EL device 2 thereon by the predetermined distance Lb2. On the other hand, the crucibles 15a to 15c as the vapor source are disposed apart from the substrate 1 by La1 which is the predetermined first distance.

Then, in the process of forming the first layer of protection film 21 as shown in FIG. 9, the shutter S1 provided for the first crucible 15a out of the shutters S1 to S3 respectively provided for the crucibles 15a to 15c is controlled to open. In other words, FIG. 9 indicates a state where the shutter S1 is not shown so that the film forming material may be evaporated from the first crucible 15a towards the substrate 1. At this point, the shutters S2 and S3 respectively provided for the second and the third crucibles 15b and 15c close the crucibles 15b and 15c, so that only the film forming material evaporated from the first crucible 15a is deposited onto the above-mentioned substrate 1 and the EL device 2 through the opening 11a formed at the mask 11 so as to be the first layer of protection film 21.

In this case, the substrate 1 is rotated in the direction of the substrate surface as indicated by "R" in the figures such that a substantially central portion of the EL device 2 formed at the substrate 1 is the rotation axis, whereby the film forming material evaporated from the crucible 15a is deposited, through the opening 11a of the above-mentioned mask 11, onto the above-mentioned EL device 2 and its periphery on the substrate 1 as the first layer of protection film 21. In this case, the first layer of protection film 21 is deposited in an area within W1 from the rotation axis corresponding to the opening 11a formed at the mask 11.

Then, as shown in FIG. 10, without changing the position (the distance Lb2) of the mask 11 relative to the substrate 11, the crucibles 15a to 15c as the vapor sources for the substrate 1 are arranged apart from the substrate 1 by the second distance La2, that is the crucibles 15a to 15c approach the substrate 1. In this state, the shutter S2 provided for the second crucible 15b out of the shutters S1 to S3 respectively provided for the crucibles 15a to 15c is controlled to open.

In other words, FIG. 10 indicates a state where the shutter S2 is not shown so that the film forming material may be evaporated from the second crucible 15b towards the substrate 1. At this point, the shutters S1 and S3 respectively provided for the first and the third crucibles 15a and 15c close the crucibles 15a and 15c, so that only the film forming material evaporated from the second crucible 15b is deposited onto the above-mentioned substrate 1 and the EL device 2 through the opening 11a formed at the mask 11 so as to be the second layer of protection film 22.

In this case, the substrate 1 is rotated in the direction of the substrate surface as indicated by "R" in the figures such that a substantially central portion of the EL device 2 formed at the substrate 1 is the rotation axis, whereby the film forming material evaporated from the crucible 15b is deposited, through the opening 11a of the above-mentioned mask 11, onto the above-mentioned EL device 2 and its periphery on the substrate 1 as the second layer of protection film 22. In this case, the second layer of protection film 22 is deposited in an area within W2 from the rotation axis corresponding to the opening 11a formed at the mask 11.

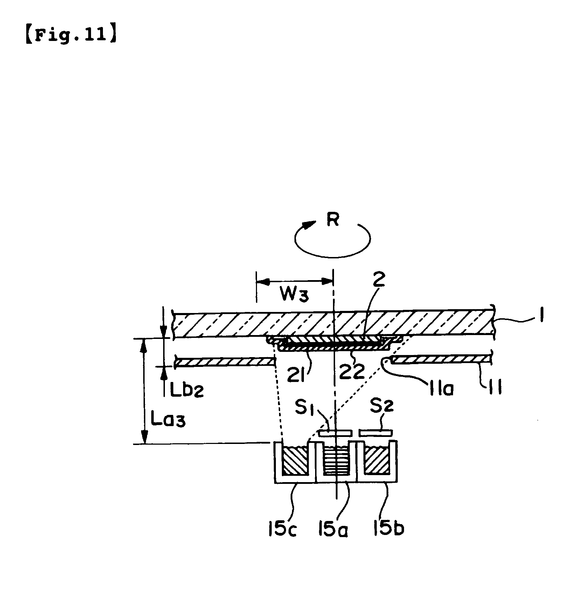

Further, as shown in FIG. 11, without changing the position (the distance Lb2) of the mask 11 from the substrate 1, the crucibles 15a to 15c as the vapor sources for the substrate 1 are arranged apart from the substrate 1 by the third distance La3, that is the crucibles 15a to 15c approach the substrate 1 closer. In this state, the shutter S3 provided for the third crucible 15c out of the shutters S1 to S3 respectively provided for the crucibles 15a to 15c is controlled to open.

In other words, FIG. 11 indicates a state where the shutter S3 is not shown so that the film forming material may be evaporated from the third crucible 15c towards the substrate 1. At this point, the shutters S1 and S2 respectively provided for the first and the second crucibles 15a and 15b close the crucibles 15a and 15b, so that only the film forming material evaporated from the third crucible 15c is deposited onto the above-mentioned substrate 1 and the EL device 2 through the opening 11a formed at the mask 11 so as to be the third layer of protection film 23.

In this case, the substrate 1 is rotated in the direction of the substrate surface as indicated by "R" in the figures such that a substantially central portion of the EL device 2 formed at the substrate 1 is the rotation axis, whereby the film forming material evaporated from the crucible 15c is deposited, through the opening 11a of the above-mentioned mask 11, onto the above-mentioned EL device 2 and its periphery on the substrate 1 as the third layer of protection film 23. In this case, the third layer of protection film 23 is deposited in an area within W3 from the rotation axis corresponding to the opening 11a formed at the mask 11.

According to the film forming methods as shown in FIG. 9 to FIG. 11, the distance of the mask 11 from the substrate 1 remains the same. The distances of the crucibles 15a to 15c from the substrate 1 are controlled to be in an expression (La1 > La2 > La3) decreasing in distance in the order of film forming. Therefore the areas from the rotation axis in respective processes have an expression W1 < W2 < W3 so that an upper layer protection film may be formed to cover beyond a lower or previous protection film in turn.

The above description is set forth until the third layer of protection film is formed, however, the fourth or more layers of protection films may be similarly formed as appropriate. As described above, when employing the film forming methods as shown in FIG. 9 to FIG. 11, operations and effects may be obtained similar to the film forming methods as shown in FIG. 6 to FIG. 8. The thus obtained structure of the protection films is similar to that shown in FIG. 5.

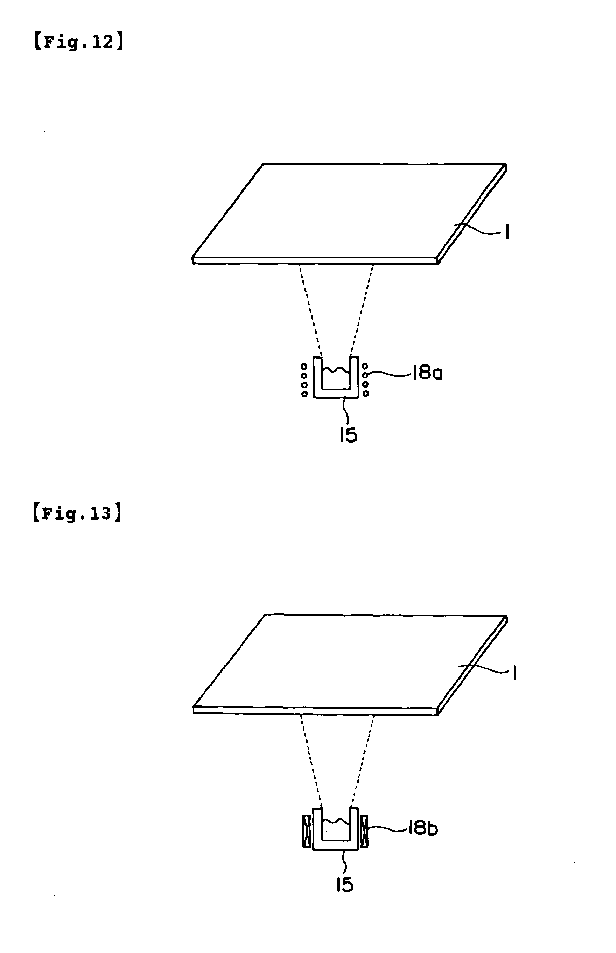

In FIG. 12 to FIG. 15 there is illustrated an example of a physical vapor-phase film forming process which may be employed in the above-described film forming methods. FIG. 12 illustrates an example of a resistance heating vacuum deposition process in which a heater 18a is provided around the crucible 15 accommodating a film forming material therein so as to be heated and evaporated by the heater 18a and to form a film on the substrate 1. FIG. 13 illustrates an example of a high-frequency induction heating vacuum deposition process in which an induction heating unit 18b is provided around the crucible 15 accommodating the film forming material therein so as to be heated and evaporated by means of high-frequency current supplied to the induction heating unit 18b and to form a film on the substrate 1.

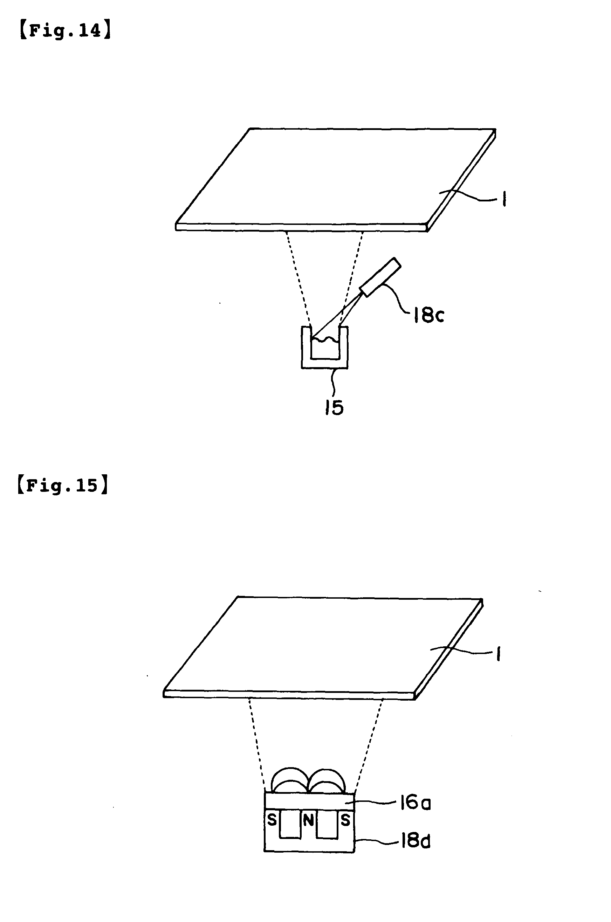

FIG. 14 illustrates an example of an electron beam heating vacuum deposition process in which the film forming material accommodated in the crucible 15 is irradiated and heated with an electron beam from an electron beam generating unit 18c so as to be evaporated and to form a film on the substrate 1. Further, FIG. 15 illustrates an example of a magnetron sputtering process in which a magnetic field intersecting an electric field generated by a magnetron apparatus 18d is applied to a material 16a, as a target, to be sputtered onto the substrate 1.

It should be understood that in the film forming method according to the present invention may employ other physical vapor-phase film forming processes such as a vapor deposition process, a plasma vapor deposition process, a molecular epitaxial process, a Krister ion beam process, an ion plating process, a plasma polymerization process. Further, although not shown, in the protection film forming method according to the present invention may employ other chemical vapor-phase film forming processes such as a plasma CVD process, a laser CVD process, a heat CVD process, a gas source CVD process. These processes are suitably selected in consideration of the material to be laminated, etc.

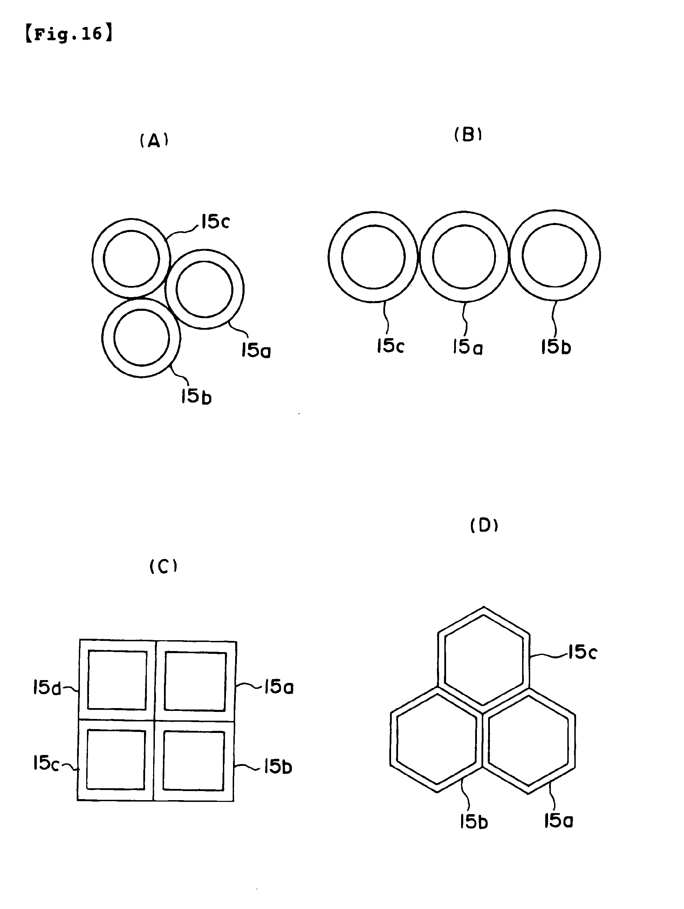

FIGS. 16(A) to 16(D) illustrate constitutions of crucibles for accommodating film forming materials available for the film forming method according to the present invention and explain arrangements of the crucibles. In particular, FIG. 16(A) shows an arrangement where the first to the third cylindrical crucibles 15a to 15c are collected in a triangular shape in plan view. FIG. 16(B) shows an arrangement where the first to the third cylindrical crucibles 15a to 15c are substantially lined in plan view.

Further, FIG. 16(C) shows an arrangement where the first to the fourth crucibles 15a to 15d formed in a cubic shape are collected in a two-by-two matrix shape in plan view. Still further, FIG. 16(D) shows an arrangement where the first to the third crucibles 15a to 15c formed in a honeycomb shape are in triangular in plan view. In the film forming methods according to the present invention, other structures or arrangements than those shown in FIGS. 16 may be employed as appropriate.

Furthermore, the film forming materials used in the film forming method according to the present invention may be inorganic or organic. As for the inorganic film forming materials, nitrides such as SiN, AlN, GaN, oxides such as SiO, AlyO₃, Ta₂O₅, ZnO, GeO, oxide-nitrides such as SiON, cyanides such as SiCN, fluorinated metals, metal films, etc. may be employed, however, it is not limited thereto.

As for the organic film forming materials, epoxy resins, acrylic resins, polyparaxylene, fluoropolymers (perfluoroolefine, perfluoroether, tetrafluoroethylene, chlorotrifluoroethylene, dichlorodifluoroethylene, etc.) metal alcoxide (CH₃OM, C₂H₅OM, etc.), polyimide precursors, perylene compounds, for example, may be employed, however, it is not limited thereto.

## Claims

1. A protection film forming method of forming at least two layers of protection films for covering an electronic component mounted on a surface of a substrate, method comprising:
a film forming step where a mask having an opening corresponding to the electronic component mounted on the surface of said substrate is disposed apart from said substrate by a predetermined first distance, and a film forming material is deposited through the opening of said mask onto said substrate and the electronic component as a first layer of protection film; and
a film forming step where said mask is disposed apart from said substrate by a second distance longer than said first distance, and a film forming material is deposited through the opening of said mask onto said substrate and the electronic component as a second layer of protection film,
wherein the steps are performed in turn, thereby at least forming the first layer of protection film covering the electronic component and the second layer of protection film for covering beyond the first layer of protection film.

2. A protection film forming method of forming at least two layers of protection films for covering an electronic component mounted on a surface of a substrate, method comprising:
a film forming step where a mask having an opening corresponding to the electronic component mounted on the surface of said substrate is disposed between said substrate and a vapor source and a film forming material from the vapor source is deposited, through the opening of the mask disposed apart from said substrate by a predetermined first distance, onto said substrate and the electronic component as a first layer of protection film; and
a film forming step where said mask is disposed apart from said substrate by a second distance longer than said first distance, and a film forming material is deposited through the opening of said mask onto said substrate and the electronic component as a second layer of protection film,
wherein said steps are performed in turn maintaining a distance between said substrate and the vapor source constant, thereby at least forming the first layer of protection film for covering the electronic component and the second layer of protection film for covering beyond the first layer of protection film.

3. The protection film forming method for covering the electronic component as claimed in claim 1 or 2, wherein the distance of said mask from said substrate is progressively set at a longer distance so as to further deposit an additional protection film onto the previous protection film and to form third or more layers of protection films for covering beyond the previous protection film.

4. A protection film forming method of forming at least two layers of protection films for covering an electronic component mounted on a surface of a substrate, method comprising:
a film forming step where a mask having an opening corresponding to the electronic component mounted on the surface of said substrate is disposed between said substrate and a vapor source, and a film forming material from the vapor source disposed apart from said substrate by a predetermined first distance is deposited through the opening of said mask onto said substrate and the electronic component as a first layer of protection film; and
a film forming step where said vapor source is disposed apart from said substrate by a second distance shorter than said first distance, and a film forming material is deposited through the opening of said mask onto said substrate and the electronic component as a second layer of protection film,
wherein said steps are performed in turn maintaining a distance between said substrate and the mask constant, thereby at least forming the first layer of protection film for covering the electronic component and the second layer of protection film for covering beyond the first layer of protection film.

5. The protection film forming method for covering the electronic component as claimed in claim 4, wherein the distance of said vapor source from said substrate is set stepwise at a shorter distance so as to further deposit an additional protection film onto the previous protection film and to form third or more layers of protection films for covering beyond the previous protection film.

6. The protection film forming method for covering the electronic component as claimed in claim 2 or 4, wherein respective crucibles having thereon a shutter for individually accommodating said film forming material are disposed in the same chamber, and in each film forming step where said protection film is deposited on the substrate and the electronic component in turn, the shutter provided for each of said crucibles is selectively opened so that the protection films of different film forming materials are formed in turn.

7. An electronic device having at least two layers of protection films so as to cover an electronic component mounted on a surface of a substrate, at least comprising:
a first layer of protection film obtained by disposing a mask having an opening corresponding to the electronic component mounted on the surface of said substrate apart from said mask by a predetermined first distance, and depositing a film forming material, through the opening of said mask, onto said substrate and the electronic component; and
a second layer of protection film obtained by disposing said mask apart from said substrate by a second distance longer than the first distance, and depositing a film forming material, through the opening of said mask, onto said substrate and the electronic component,
wherein the second layer of protection film is formed on said first layer of protection film so as to cover beyond the first layer of protection film.

8. An electronic device having at least two layers of protection films so as to cover an electronic component mounted on a surface of a substrate, at least comprising:
a first layer of protection film obtained by disposing a mask having an opening corresponding to the electronic component mounted on the surface of said substrate between said substrate and a vapor source and depositing a film forming material from the vapor source, through the opening of the mask apart from said substrate by a predetermined first distance, onto said substrate and the electronic component; and
a second layer of protection film obtained by disposing said mask apart from said substrate by a predetermined second distance longer than the first distance, and depositing a film forming material, through the opening of said mask, onto said substrate and the electronic component,
wherein the second layer of protection film is formed on said first layer of protection film so as to cover beyond the first layer of protection film.

9. An electronic device having at least two layers of protection films so as to cover an electronic component mounted on a surface of a said substrate, at least comprising:
a first layer of protection film obtained by disposing a mask having an opening corresponding to the electronic component mounted on the surface of said substrate between said substrate and a vapor source and depositing a film forming material from the vapor source, through the opening of said mask apart from said substrate by a predetermined first distance, onto said substrate and the electronic component; and
a second layer of protection film obtained by disposing said vapor source apart from said substrate by a second distance shorter than the first distance, and depositing a film forming material from the vapor source, through the opening of said mask, onto said substrate and the electronic component,
wherein the second layer of protection film is formed on said first layer of protection film so as to cover beyond the first layer of protection film.

10. The electronic device having the protection films as claimed in any one of claims 7 to 9, wherein said substrate is formed of a transparent material, and the electronic component mounted on the surface of said substrate is an organic EL device having at least a first electrode laminated to and formed on the substrate, an organic luminescence material layer, and a second electrode.
